# EUROPÄISCHE PATENTSCHRIFT

(11) **EP 1 448 577 B1**
(45) Veröffentlichungstag und Bekanntmachung des Hinweises auf die Patenterteilung: **07.06.2006**
(21) Anmeldenummer: 02785365.4
(22) Anmeldetag: 07.11.2002
(51) Int. Cl.: C07F 15/00, C09K 11/06, H01L 51/42

(54) **RHODIUM- UND IRIDIUM-KOMPLEXE**
RHODIUM AND IRIDIUM COMPLEXES
COMPLEXES RHODIUM ET IRIDIUM

(30) Priorität: 09.11.2001 DE 10155064
(43) Veröffentlichungstag der Anmeldung: 25.08.2004
(73) Patentinhaber: Merck Patent GmbH, 64293 Darmstadt (DE)
(72) Erfinder: STÖSSEL, Philipp, 65929 Frankfurt (DE); SPREITZER, Hubert, 68519 Viernheim (DE); BECKER, Heinrich, 61479 Glashütten (DE)
(74) Vertreter: Benz, Jürgen
(86) Internationale Anmeldenummer: PCT/EP2002/012416
(87) Internationale Veröffentlichungsnummer: WO 2003/040160

(56) Entgegenhaltungen:
- BALDO, M.A. ET AL.: "very high-efficiency green organic light-emitting devices based on electrophosphorescence" APPLIED PHYSICS LETTERS, Bd. 75, 1999, Seiten 4-6, XP002199390 in der Anmeldung erwähnt

## Beschreibung

Metallorganische Verbindungen - speziell Verbindungen der d⁸ -Metallewerden in naher Zukunft als Wirkkomponenten (= Funktionsmaterialien) in einer Reihe von verschiedenartigen Anwendungen, die im weitesten Sinne der Elektronikindustrie zugerechnet werden können, Einsatz als funktionelle Komponenten finden.
Bei den auf organischen Komponenten basierenden Organischen-Elektrolumineszenz-Vorrichtungen (allg. Beschreibung des Aufbaus vgl.
US-A-4,539,507 und US-A-5,151,629) bzw. deren Einzelbauteilen, den Organischen-Lichtemittierenden-Dioden (OLEDs) ist die Markteinführung bereits erfolgt, wie die erhältlichen Auto-Radios mit "Organischem Display" der Firma Pioneer belegen. Weitere derartige Produkte stehen kurz vor der Einführung. Trotz allem sind hier noch deutliche Verbesserungen nötig, um diese Displays zu einer echten Konkurrenz zu den derzeit marktbeherrschenden Flüssigkristallanzeigen (LCD) zu machen bzw. diese zu überflügeln.
Eine Entwicklung hierzu, die sich in den letzten beiden Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, **1999,** 75, 4-6].
Aus theoretischen Spin-statistischen Gründen ist unter Verwendung metallorganischer Verbindungen als Phosphoreszenz-Emittern eine bis zu vierfache Energie- und Leistungseffizienz möglich. Ob sich diese neue Entwicklung durchsetzten wird, hängt stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Daneben muß der effiziente chemische Zugang zu den entsprechenden Organo-Metall-Verbindungen gegeben sein. Von besonderem Interesse sind dabei Organo-Rhodium- und Iridium-Verbindungen. Bei diesen ist vor allem unter Berücksichtigung des Rhodium- bzw. des Iridiumpreises von maßgebender Bedeutung, daß hier ein effizienter Zugang zu entsprechenden Derivaten ermöglicht wird.

5'-Mono-, 5',5"-Di- und 5',5",5"'-Tri-Formylierte tris-orthometallierte Organo-Rhodium- und Organo-Iridium-Verbindungen (gemäß Verbindungen (I) oder (II)), die Gegenstand der vorliegenden Erfindung sind, werden zentrale Schlüsselbausteine zur Erzeugung hocheffizienter Triplett-Emitter sein, da die Aldehydfunktion mit Hilfe von gängigen, in der Literatur beschriebenen Methoden in eine Vielzahl von Funktionen umgewandelt werden kann. Damit ist nicht nur der kovalente Einbau dieser aktiven, lichtemittierenden Zentren in eine Vielzahl von Polymeren möglich, sondern auch das Maßschneidern der optoelektronischen Eigenschaften dieser Bausteine. So sind hier - ausgehend von den genannten Strukturen - typische -C=C-Verknüpfungsreaktionen (z. B. Wittig- oder Wittig-Horner-Reaktion), oder auch C-Heteroatom-Verknüpfungsreaktionen (z. B. für C=N: Imin- bzw. Schiffsche-Basen-Bildung) möglich, um damit die formylierten Verbindungen entweder weiter zu funktionalisieren, oder als (Co)monomere bei der Darstellung von entsprechenden Polymeren zu verwenden.

5'-Mono-, 5',5"-Di- und 5',5",5"'-Tri-formylierte tris-orthometallierte Organo-Rhodium- und Organo-Iridium-Verbindungen sowie Verfahren zu ihrer Herstellung sind bisher in der Literatur nicht beschrieben worden. Diese gilt insbesondere für die Formylierung aromatischer - an das Metallzentrum gebundener - Liganden, d. h. der Formylierung am Metall-Komplexes. Ein Vergleich mit dem Stand der Technik ist dementsprechend nicht möglich. Die effiziente Darstellung und Verfügbarkeit dieser Aldehyde als Reinstoffe ist aber für verschiedene elektro-optische Anwendungen von großer Bedeutung.

Es wurde überraschend gefunden, daß die neuen Verbindungen (I) oder (II) - gemäß Schema 1 - ausgehend von den tris-orthometallierten Organo-Rhodium bzw. Organo-Iridium-Verbindungen (III) bzw. (IV) und einem Formylierungsagens bestehend aus einem Formamid und einem anorganischem bzw. organischem Säurehalogenid bzw. einem Dihalogenether und einer Lewissäure unter geeigneter Wahl des stöchiometrischen Verhältnisses des entsprechenden Formylierungsagenz zu den Verbindungen (III) bzw. (IV), sowie unter geeigneter Wahl der Reaktionsparameter wie Reaktionstemperatur, Reaktionsmedium, Konzentration und Reaktionszeiten reproduzierbar in etwa 70 - 90 % iger Ausbeute, ohne Verwendung chromatographischer Reinigungsverfahren, in Reinheiten von > 99 % nach NMR bzw. HPLC erhalten werden (siehe Beispiel 1 -4).

Das oben beschriebene Verfahren zeichnet sich durch drei Eigenschaften besonders aus:

Erstens ist die selektive 5'-Mono-, 5',5"-Di- und 5',5",5"'-Tri-Formylierung unerwartet und in dieser Form nicht bekannt. Vermutlich resultiert sie aus der Aktivierung, die die zum Rhodium- bzw. Iridium-Atom para-ständige Position durch dieses erfährt. Die unerwartet hohe Aktivität dieser Position gegenüber einer elektrophilen Substitution, hier der Formylierung, wird durch den Einsatz milder Formylierungsagentien gezielt ausgenutzt.

Zweitens ist der hohe erzielte Umsatz, der sich in den reproduzierbar sehr guten Ausbeuten an isoliertem Produkt wiederspiegelt, unerwartet und einzigartig für die Formylierung von orthometallierten Liganden, gebunden an Metalle der Eisentriade.

Drittens fallen die erhaltenen Verbindungen, ohne aufwendige chromatographische Reinigung, in sehr guten Reinheiten von > 99 % nach NMR bzw. HPLC an. Dies ist für die Verwendung in opto-elektronischen Bauelementen, bzw. der Benutzung als Zwischenprodukte für die Darstellung entsprechender Verbindungen essentiell.

Wie oben geschildert, sind die erfindungsgemäßen Verbindungen nicht vorbeschrieben und damit neu.

Gegenstand der vorliegenden Erfindung sind somit die Verbindungen (I) und (II) gemäß Schema 1, 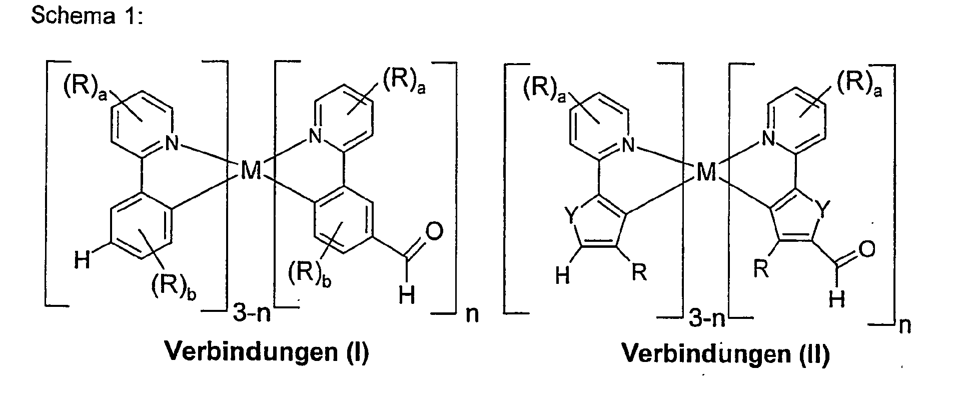 wobei die Symbole und Indizes folgende Bedeutung haben:
- M: Rh, Ir
- Y: O, S, Se
- R: ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR²⁻ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹ und R²: sind gleich oder verschieden, H oder ein aliphatischer oder aromatischer Kohlenwasserstoffrest mit 1 bis 20 C-Atomen,
- a: ist 0, 1, 2, 3 oder 4, bevorzugt 0, 1 oder 2,
- b: ist 0, 1, 2 oder 3, bevorzugt 0 oder 1.
- n: ist 1, 2 oder 3

Eine weitere Ausführungsform der Erfindung sind solche Rh- bzw. Ir-komplexe, die gleichzeitig Liganden vom Typ wie bei Verbindungen (I) und solche von

Verbindungen (II) aufweisen, d.h. gemischte Ligandensysteme. Diese werden durch die Formeln (Ia) und (IIa) beschrieben: 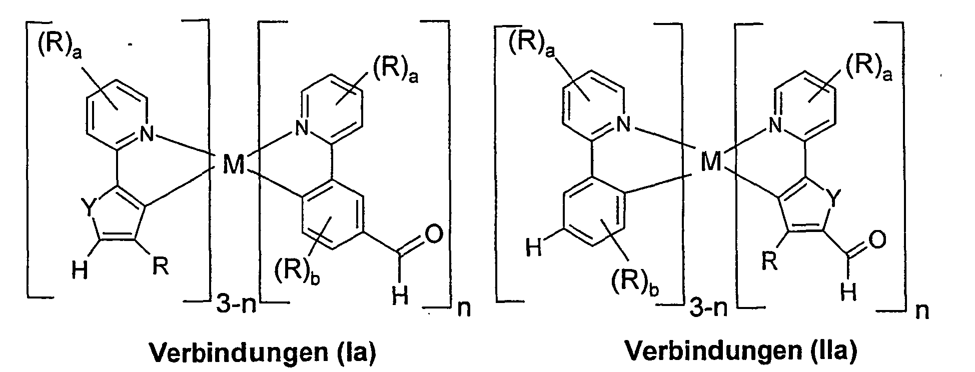 wobei die Symbole und Indizes die unter den Formel (I) und (II) genannten Bedeutungen haben.

Ein weiterer Gegenstand der vorliegenden Erfindung sind Verfahren zur Herstellung der Verbindungen (I) bzw. (II), durch Umsetzung der Verbindungen (III) bzw. (IV), 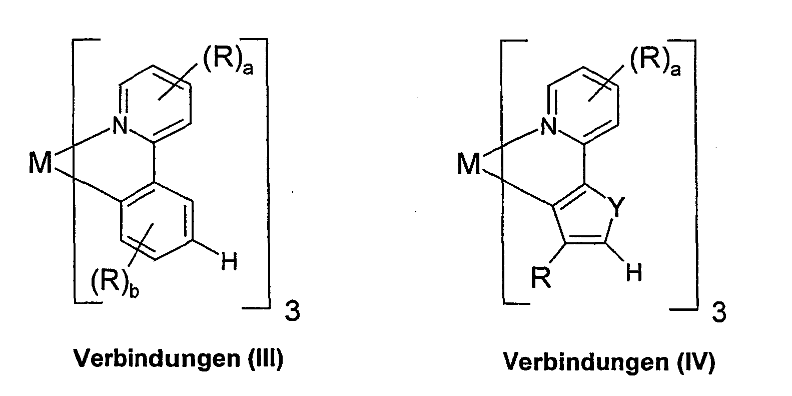 worin M und die Reste und Indizes Y, R, a, und b die oben genannten Bedeutungen haben, mit Formylierungsagentien.
Die Verbindungen (III) und (IV) sind beispielsweise aus der Anmeldung WO 02/060910 bekannt.

Das erfindungsgemäße Verfahren wird durch Schema 2 erläutert:

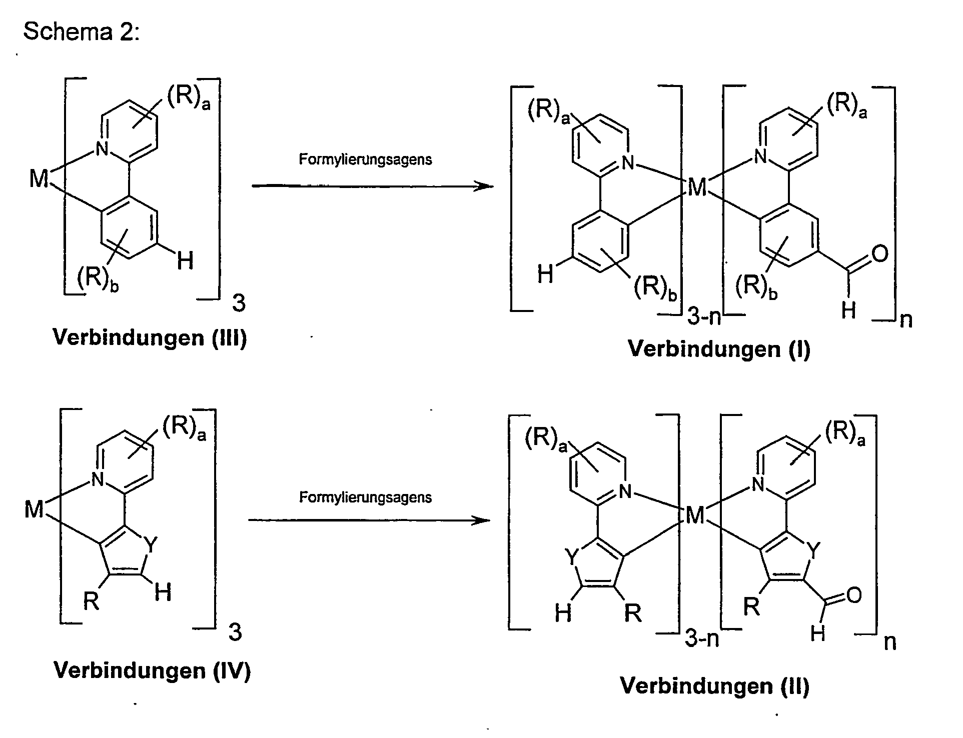

Erfindungsgemäße Formylierungsagentien sind Formamide und ein anorganisches bzw. organisches Säurehalogenid im molaren Verhältnis 1 : 1 bis 100 : 1, so z.B. N-Methyl-formamid (MFA), N,N-Dimethyl-formamid (DMF), N-Methyl-formanilid in Kombination mit Phosphoroxidtrichlorid, Thionylchlorid, Sulfurylchlorid und Oxalylchlorid.

Diese Formylierungsagentien werden nachfolgend Formylierungsagentien (1) genannt. Bei Angabe von stöchiometrischen Verhältnissen dieser Formylierungsagentien (1) zu anderen Verbindungen ist die molare Menge an anorganischem bzw. organischem Säurehalogenid im Gemisch aus Formamid und Säurehalogenid Bezugsbasis.

Weitere erfindungsgemäße Formylierungsagentien sind organische Dihalogen-methyl-ether und Lewissäuren im Verhältnis 1 : 1 bis 1 : 4, so z.B. 1,1-Dichlor-methoxy-methan, -ethan, -propan bzw. -butan in Kombination mit Titan(IV)chlorid, Zinn(IV)chlorid oder Aluminium(III)chlorid.

Diese Formylierungsagentien werden nachfolgend Formylierungsagentien (2) genannt.
Bei Angabe von stöchiometrischen Verhältnissen dieser Formylierungsagentien (2) zu anderen Verbindungen ist die molare Menge an Dihalogen-methyl-ether Bezugsbasis.

Im erfindungsgemäßen Verfahren führt ein stöchiometrisches Verhältnis der Formylierungsagentien (1) oder (2) zu den Verbindungen (III) oder (IV) von 1 : 1 selektiv zu den Verbindungen (I) oder (II) mit n = 1. Dies ist ein überraschendes und nicht vorhersehbares Ergebnis.

Im erfindungsgemäßen Verfahren führt ein stöchiometrisches Verhältnis der Formylierungsagentien (1) oder (2) zu den Verbindungen (III) oder (IV) von 2 : 1 selektiv zu den Verbindungen (I) oder (II) mit n = 2. Dies ist ein überraschendes und nicht vorhersehbares Ergebnis.

Im erfindungsgemäßen Verfahren führt ein stöchiometrisches Verhältnis der Formylierungsagentien (1) oder (2) zu den Verbindungen (III) oder (IV) von 3: 1 bis 100 : 1 selektiv zu den Verbindungen (I) oder (II) mit n = 3. Dies ist ein überraschendes und nicht vorhersehbares Ergebnis.

Die hier beschriebenen stöchiometrischen Verhältnisse sind bevorzugte Ausführungsformen der vorliegenden Erfindung, da sie zu einheitlich substituierten Produkten führen. Es ist selbstverständlich, daß leichte Abweichungen von den o. g. Verhältnissen immer noch zu guten bis akzeptablen Ergebnissen führen.

Erfindungsgemäße Reaktionsmedien sind bei Anwendung der Formylierungsagentien (1) zum einen die Formamide selbst, die sowohl als Bestandteil des Formylierungsagens als auch als Reaktionsmedium dienen. Zum anderen können weitere Co-Solventien wie Ether so z. B. Diethylether, Di-n-butylether, Methyl-*tert*-butylether, Tetrahydrofuran oder Dioxan, halogenierte Kohlenwasserstoffe wie Dichlormethan, Chloroform oder 1,2-Dichlorethan und nicht reaktive aromatische Kohlenwasserstoffe wie Chlorbenzol, o-, m-, p-Dichlorbenzol oder Mischungen dieser, Toluol, o-, m-, p-Xylol oder Mischungen dieser eingesetzt werden.
Erfindungsgemäße Reaktionsmedien sind bei Anwendung der Formylierungsagentien (2) aprotische Lösungsmittel wie Dichlormethan, Chloroform, 1,2-Dichlorethan, 1,1,2,2-Tetrachlorethan und Schwefelkohlenstoff.

Erfindungsgemäß wird die Umsetzung im Temperaturbereich von -10°C bis 120°C, bevorzugt bei 0°C bis 100°C, ganz bevorzugt bei 0°C bis 80°C durchgeführt.

Erfindungsgemäß liegt die Konzentration der Rhodium-haltigen bzw. Iridium-haltigen Edukte - Verbindungen (III) bzw. Verbindungen (IV) - im Bereich von 0.0005 mol/l bis 2 mol/l, besonders bevorzugt im Bereich von 0.002 mol/l bis 0.5 mol/l.

Erfindungsgemäß können die Rhodium-haltigen bzw. Iridium-haltigen Edukte gelöst oder suspendiert im Reaktionsmedium vorliegen.

Erfindungsgemäß wird die Reaktion innerhalb von 10 Minuten bis zu 100 Stunden durchgeführt, bevorzugt innerhalb von 1 h bis 60 h.

Mit den hier erläuterten Synthesemethoden lassen sich unter anderem die im folgenden dargestellten Beispiele für Verbindungen (1) bzw. (II) herstellen.

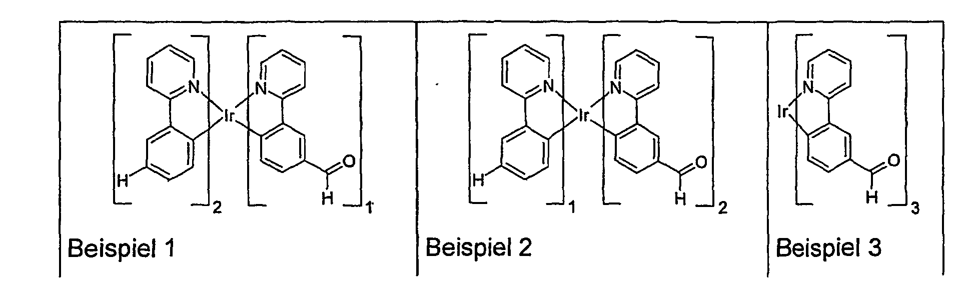

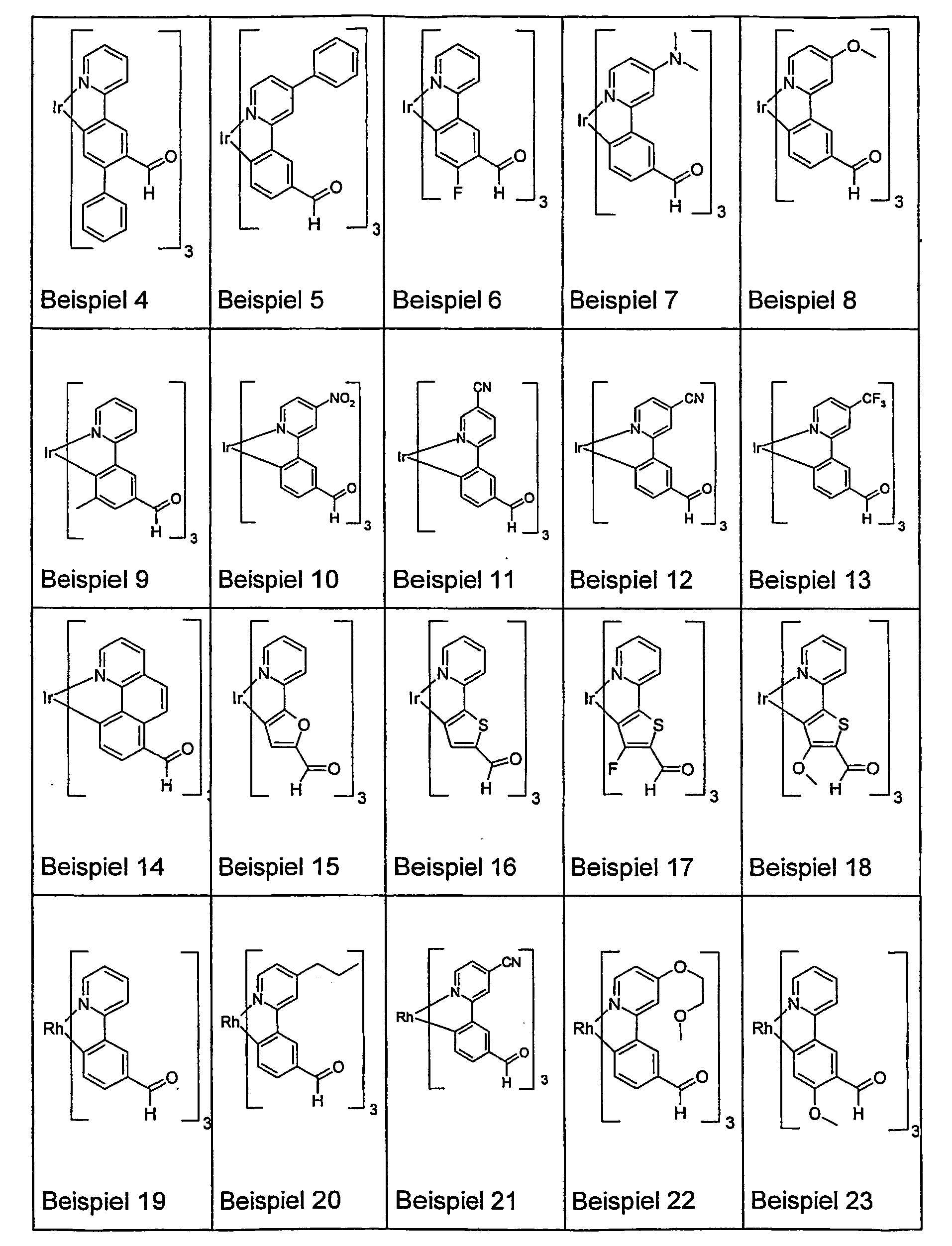

Die so erhaltenen erfindungsgemäßen Verbindungen können nun beispielsweise als Co-Monomere für Erzeugung entsprechender konjugierter oder auch teilkonjugierter Homo- oder Copolymere Verwendung finden. So können sie u. a. in lösliche Polyfluorene (z. B. gemäß EP-A-842208 oder WO 00/22026), Poly-spirobifluorene (z. B. gemäß

EP-A- 707020, EP-A-894107), Poly-para-phenylene (z. B. gemäß WO 92/18552), Poly-carbazole oder auch Polythiophene (z. B. gemäß EP-A-1028136) einpolymerisiert werden.

Die in EP-A-842208 und WO 00/22026 offenbarten Polyfluorene sowie deren Homo- und Copolymere sind Bestandteil dieser Beschreibung.

Die in EP-A-707020 und EP-A-894107 offenbarten Poly-spirobifluorene sowie deren Homo- und Copolymere sind Bestandteil dieser Beschreibung.

Die in WO 92/18552 offenbarten Poly-para-phenylene sowie deren Homo- und Copolymere sind Bestandteil dieser Beschreibung.

Die in EP-A-1028136 offenbarten Polythiophene sowie deren Homo- und Copolymere sind Bestandteil dieser Beschreibung.

Die oben genannten Polymere können in elektronischen Bauteilen, wie organische Leuchtdioden (OLEDs), organischen integrierten Schaltungen (O-ICs), organischen Feld-Effekt-Transistoren (OFETs), organischen Dünnfilmtransistoren (OTFTs), organischen Solarzellen (O-SCs), organischen Laserdioden (O-Laser), organischen Farbfilter für Liquid-Crystal-Displays oder organischen Photorezeptoren, Verwendung finden.

Weiterhin können die erfindungsgemäßen Verbindungen natürlich auch durch die beispielsweise in der Einleitung genannten Reaktionstypen weiter funktionalisiert werden, und so zu erweiterten niedermolekularen Rh- oder Ir-Komplexen umgesetzt werden. Hier ist als Beispiel die Funktionalisierung mit Phosphonium-Salzen bzw. Phosphonaten gem. Wittig bzw. Wittig-Horner oder mit Aminen unter Wasserabspaltung zu Iminen bzw. Schiffschen-Basen zu nennen.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Komplexe herstellen bzw. das erfindungsgemäße Verfahren anwenden.

### 1. Synthese von symmetrisch und asymmetrisch formylierten tris-orthometallierten Organo-Rhodium- bzw. Organo-iridium-Verbindungen:

Die nachfolgenden Synthesen wurden - sofern nicht anders angegeben - unter einer Schutzgasatmosphäre und Verwendung trockener Lösungsmittel durchgeführt. Die Edukte wurden von der Fa. ALDRICH [N,N-Dimethylformamid,
Phosphoroxidtrichlorid, 1,1-Dichlormethyl-methylether, Zinn(IV)chlorid] bezogen. *fac-*Tris[2-(2-pyridinyl-κN)phenyl-κC]-iridium(III) wurde wie in der Anmeldung WO 02/060910 beschrieben dargestellt.

Numerierungsschema für die Zuordnung der ¹H-NMR-Signale [nach: C. Coudret, S. Fraysse, J.-P- Launay, Chem. Commun., **1998**, 663-664]:

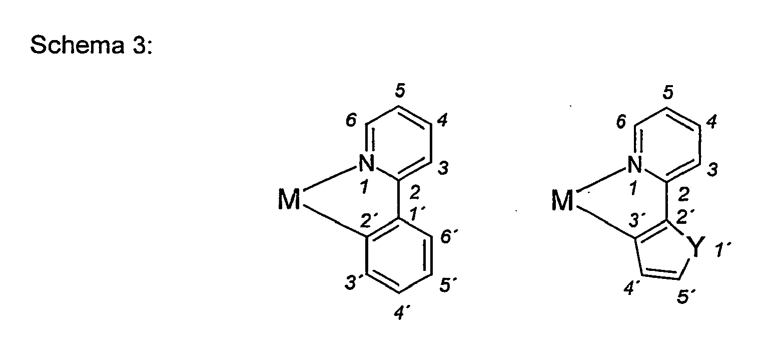

### Beispiel 1: fac-Bis[2-(2 pyridinyl-κN)phenyl-κC]-[2-(2-pyridinyl-κN) (5-formylphenyl)-κC]-iridium(III)

80 ml N,N-Dimethyl-formamid wurden unter Rühren während 5 min. tropfenweise mit 1.53 g = 930 µl (10 mmol) Phosphoroxidtrichlorid versetzt. Nach beendeter Zugabe wurde diese Mischung 1 h bei Raumtemperatur gerührt. In diese Mischung trugt man auf einmal 6.548 g (10 mmol) *fac*-Tris[2-(2-pyridinyl-κN)phenyl-κC)-iridium(III) ein und erhitzte die gelbe Suspension auf 80°C. Nach 40 h Rühren bei 80°C ließ man die tiefrote Lösung auf Raumtemperatur erkalten und goß diese in 300 ml wäßrige 1 N NaOH. Nach 1 h wurde die gelbe Mischung zweimal mit 150 ml Dichlormethan extrahiert, die vereinigten organischen Phasen wurden dreimal mit 200 ml Wasser gewaschen und anschießend über Magnesiumsulfat getrocknet. Nach Abfiltrieren und einengen der organischen Phase wurde der erhaltene Feststoff zweimal aus Toluol / Ethanol umkristallisiert und abschließend im Vakuum (60°C, 10⁻⁴ mbar) getrocknet. Die Ausbeute - bei einer Reinheit von > 99.5% nach ¹H-NMR - betrug 5.74 g - 5.92 g entsprechend 84.0 - 86.7 %.
¹HNMR (DMSO-d6): [ppm] = 9.78 (s, 1H, C(O)H), 8.13 - 8.10 (m, 1 H), 8.02 - 7.99 (m, 2 H), 7.84 - 7.98 (m, 1 H), 7.61 - 7.42 (m, 5 H), 7.16 - 7.14 (m, 1 H), 6.92 - 6.75 (m, 12 H), 6.68-6.65 (m, 1 H).

### Beispiel 2: fac-[2-(2-pyridinyl-κN)phenyl-κC]-bis[2-(2-pyridinyl-κN)(5-formylphenyl)-κC]-iridium(III)

80 ml N,N-Dimethyl-formamid wurden unter Rühren während 5 min. tropfenweise mit 3.07 g = 1.86 ml (20 mmol) Phosphoroxidtrichlorid versetzt. Nach beendeter Zugabe wurde diese Mischung 1 h bei Raumtemperatur gerührt. In diese Mischung trugt man auf einmal 6.548 g (10 mmol) *fac*-Tris[2-(2-pyridinyl-κN)phenyl-κC]-iridium(III) ein und erhitzte die gelbe Suspension auf 80°C. Nach 40 h Rühren bei 80°C ließ man die tiefrote Lösung auf Raumtemperatur erkalten und goß diese in 300 ml wäßrige 1 N NaOH. Nach 1 h wurde die gelbe Mischung zweimal mit 150 ml Dichlormethan extrahiert, die vereinigten organischen Phasen wurden dreimal mit 200 ml Wasser gewaschen und anschießend über Magnesiumsulfat getrocknet. Nach Abfiltrieren und Einengen der organischen Phase wurde der erhaltene Feststoff zweimal aus Toluol / Ethanol umkristallisiert und im Vakuum (60°C, 10⁻⁴ mbar) getrocknet. Die Ausbeute - bei einer Reinheit von > 99.5% nach ¹H-NMR-betrug 5.79 g - 6.02 g entsprechend 81.4 - 84.7 %.
¹HNMR (DMSO-d6): [ppm] = 9.82 (s, 2 H, C(O)H), 8.13 - 8.10 (m, 2 H), 8.02 - 7.99 (m, 1 H), 7.84 - 7.98 (m, 2 H), 7.61 - 7.42 (m, 3 H), 7.16 - 7.14 (m, 2 H), 6.92 - 6.75 (m, 10 H), 6.68 - 6.65 (m, 2 H).

### Beispiel 3: fac-Tris[2-(2-pyridinyl-κN)(5-formylphenyl)- κ:C]-iridium(III)

200 ml N,N-Dimethyl-formamid wurden unter Rühren und Eiskühlung während 30 min. tropfenweise mit 61.33 g = 37.3 ml (400 mmol) Phosphoroxidtrichlorid versetzt. Nach beendeter Zugabe wurde diese Mischung 1 h bei Raumtemperatur gerührt. In diese Mischung trugt man auf einmal 6.548 g (10 mmol) fac-Tris[2-(2-pyridinyl-κN)phenyl-κC]-iridium(III) ein und erhitzte die gelbe Suspension auf 80°C. Nach 16 h Rühren bei 80°C ließ man die tief rote Lösung auf Raumtemperatur erkalten und goß diese in eine gut gerührte Mischung aus 100 ml Ethanol und 800 ml wäßrige 1 N NaOH. Nach 10 h wurde der gelbe feinkristalline Niederschlag abgesaugt (P 3), fünfmal mit 50 ml Wasser und einmal mit 20 ml eiskaltem Ethanol gewaschen. Nach zweimaliger Umkristallisation aus Toluol / Ethanol wurde der Feststoff im Vakuum (60°C, 10⁻⁴ mbar) getrocknet. Die Ausbeute - bei einer Reinheit von > 99.5% nach ¹H-NMR - betrug 5.92 g - 6.16 g entsprechend 80.1 - 83.3 %. ¹HNMR (CDCl₃): [ppm] = 9.87 (s, 3 H, C(O)H), 8.18 (d, 3 H, ⁴J_{HH} = 1.7 Hz, H6'), 8.08 (br. dd, 3 H, ³J_{HH} = 8.4 Hz, ⁴J_{HH} = 1.7 Hz , H6), 7.75 (ddd, 3 H, ³J_{HH} = 8.4 Hz, ³J_{HH} = 6.6 Hz, ⁴J_{HH} = 1.3 Hz, H5), 7.51 (dd, 3 H, ³J_{HH} = 5.1 Hz, ⁴J_{HH} = 1.3 Hz, H3), 7.03 (ddd, 3 H, ³J_{HH} = 6.6 Hz, ³J_{HH} = 5.1 Hz, ⁴J_{HH} = 1.7 Hz , H4), 7.25 (dd, 3 H, ³J_{HH} = 7.7 Hz, ⁴J_{HH} = 1.7 Hz, H4'), 6.98 (d, 3 H, ³J_{HH} = 7.7 Hz, H3').

### Beispiel 4: fac-Tris[2-(2 pyridinyl-κN)(5-formylphenyl)- κC]-iridium(III)

Eine auf 0°C gekühlte Suspension von 6.548 g (10 mmol) fac-Tris[2-(2-pyridinyl-κN)phenyl-κC]-iridium(III) in 500 ml Dichlormethan wurde mit 60 ml 1 M Zinn(IV)chloridl-Lösung in Dichlormethan (60 mmol) und anschießend mit 3.45 g = 2.7 ml (30 mmol) 1,1-Dichormethyl-methylether tropfenweise versetzt. Man ließ die rot-braune Reaktionsmischung auf Raumtemperatur erwärmen und rührte sie weitere 45 min. Nach Hydrolyse durch Zugabe von 200 g Eis wurde die organische Phase abgetrennt, 3mal mit 200 ml gesättigter Natriumhydrogencarbonat-Lösung gewaschen und über Magnesiumsulfat getrocknet. Nach Abfiltrieren des Trockenmittels und Einengen der organischen Phase wurde der gelbe Feststoff zweimal aus Toluol / Ethanol umkristallisiert und im Vakuum (60°C, 10⁻⁴ mbar) getrocknet. Die Ausbeute - bei einer Reinheit von > 99.0% nach ¹H-NMR - betrug 5.51 g - 5.78 g entsprechend 74.5 - 78.2 %.
¹HNMR (CDCl₃), siehe Beispiel 3.

## Patentansprüche

1. Verbindung gemäß Formel (I) und (II), 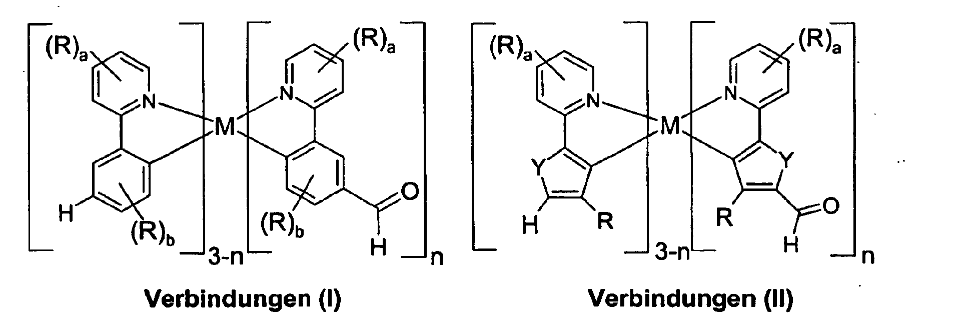 wobei die Symbole und Indizes folgende Bedeutung haben:
M ist gleich Rh, Ir
Y ist gleich oder verschieden O, S, Se
R ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen,
a ist gleich oder verschieden 0, 1, 2, 3 oder 4, bevorzugt 0, 1 oder 2,
b ist gleich oder verschieden 0, 1, 2 oder 3, bevorzugt 0 oder 1.
n ist 1, 2 oder 3.

2. Verbindung gemäß Formel (la) und (IIa) 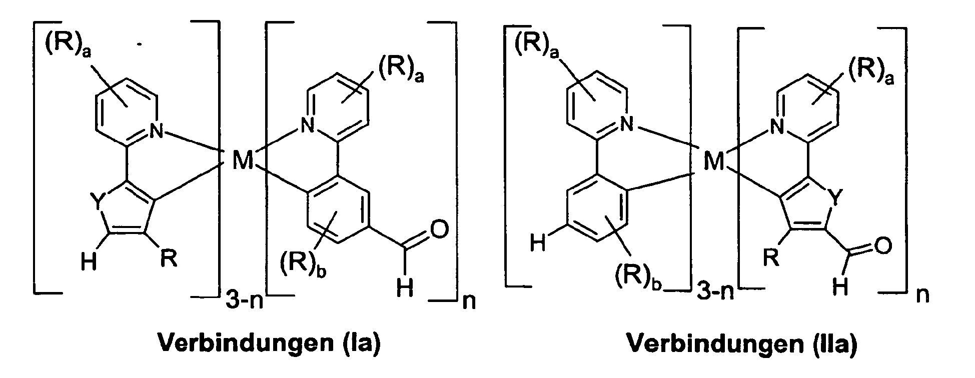 wobei die Symbole und Indizes folgende Bedeutung haben:
M ist gleich Rh, Ir
Y ist gleich oder verschieden O, S, Se
R ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder-CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen,
a ist gleich oder verschieden 0, 1, 2, 3 oder 4, bevorzugt 0, 1 oder 2,
b ist gleich oder verschieden 0, 1, 2 oder 3, bevorzugt 0 oder 1.
n ist 1, 2 oder 3.

3. Verfahren zur Herstellung der Verbindungen definiert in Anspruch 1, durch Umsetzung der Verbindungen (III) bzw. (IV), 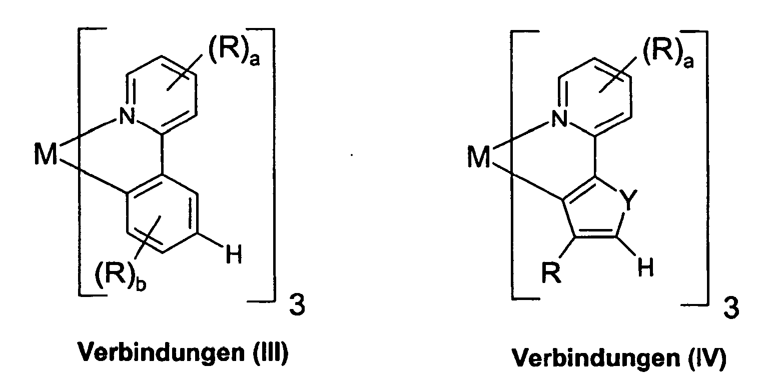 worin M und die Reste und Indizes Y, R, a, und b die in Anspruch 1 genannten Bedeutungen haben, mit Formylierungsagentien.

4. Verfahren gemäß Anspruch 3, **dadurch gekennzeichnet, daß** als Formylierungsagentien Formamide und ein anorganisches bzw. organisches Säurehalogenid im Verhältnis 1 : 1 bis 100 : 1 verwendet werden.

5. Verfahren gemäß Anspruch 4, **dadurch gekennzeichnet, daß** als Formamid N-Methyl-formamid (MFA), N,N-Dimethyl-formamid (DMF), N-Methyl-formanilid verwendet werden.

6. Verfahren gemäß Anspruch 4 und/oder 5, **dadurch gekennzeichnet, daß** als anorganische bzw. organische Säurehalogenide Phosphoroxidtrichlorid, Thionylchlorid, Sulfurylchlorid und Oxalylchlorid verwendet werden.

7. Verfahren gemäß Anspruch 3, **dadurch gekennzeichnet, daß** als Formylierungsagentien organische Dihalogen-methyl-ether und Lewissäuren im Verhältnis 1 : 1 bis 1 : 4 verwendet werden.

8. Verfahren gemäß Anspruch 7, **dadurch gekennzeichnet, daß** als Dihalogen-methyl-ether 1,1-Dichlor-methoxy-methan, -ethan, -propan oder -butan verwendet werden.

9. Verfahren gemäß Anspruch 7, **dadurch gekennzeichnet, daß** als Lewissäuren Titan(IV)chlorid, Zinn(IV)chlorid oder Aluminium(III)chlorid verwendet werden.

10. Verfahren gemäß Anspruch 3, **dadurch gekennzeichnet, daß** ein stöchiometrisches Verhältnis der Formylierungsagentien gemäß den Ansprüchen 4 oder 7 zu den Verbindungen (III) oder (IV) von 1 : 1 verwendet wird.

11. Verfahren gemäß Anspruch 3, **dadurch gekennzeichnet, daß** ein stöchiometrisches Verhältnis der Formylierungsagentien gemäß den Ansprüchen 4 oder 7 zu den Verbindungen (III) oder (IV) von 2: 1 verwendet wird.

12. Verfahren gemäß Anspruch 3, **dadurch gekennzeichnet, daß** ein stöchiometrisches Verhältnis der Formylierungsagentien gemäß den Ansprüchen 4 oder 7 zu den Verbindungen (III) oder (IV) von 3 : 1 bis 100 : 1 verwendet wird.

13. Verbindungen gemäß Anspruch 1 oder 2, **dadurch gekennzeichnet, daß** ihre Reinheit (mittels 1 H-NMR bzw. HPLC bestimmt) mehr als 99% beträgt.

14. Verwendung von Verbindungen gemäß Anspruch 1 oder Anspruch 2 zur Erzeugung konjugierter oder teilkonjugierter Homo- oder Copolymere.

15. Elektrisches Bauteil enthaltend konjugierte oder teilkonjugierte Homo- oder Copolymere welche durch Verwendung von Verbindungen gemäß Anspruch 1 oder 2 erzeugt wurden.

16. Bauteil gemäß Anspruch 15, **dadurch gekennzeichnet, daß** es sich um eine organische Leuchtdiode (OLEDs), eine organische integrierte Schaltung (O-ICs), einen organischen Feld-Effekt-Transistor (OFETs), einen organischen Dünnfilmtransistoren (OTFTs), eine organische Solarzelle (O-SCs), eine organische Laserdiode (O-Laser), einen organischen Farbfilter für Liquid-Crystal-Displays oder einen organischen Photorezeptoren handelt.

## Claims

1. A compound according to formulae (I) and (II) 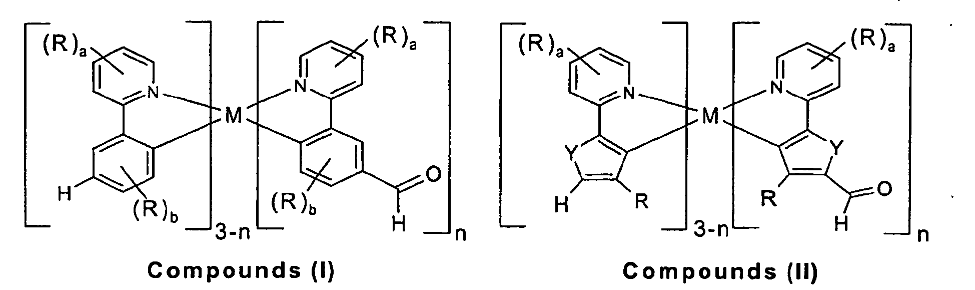 wherein the symbols and indices have the following meanings:
M is Rh, Ir;
Y is the same or different O, S, Se;
R is the same or different on each occurrence H, F, Cl, Br, NO₂, CN, a straight-chain or branched or cyclic alkyl or alkoxy group having from 1 to 20 carbon atoms, wherein one or more non-adjacent CH₂ groups may have been replaced by -O-, -S-, -NR¹- or -CONR²- and wherein one or more H atoms may have been replaced by F, or an aryl or heteroaryl group having from 4 to 14 carbon atoms which may be substituted by one or more, non-aromatic radicals R; a plurality of substituents R, both at the same ring and at the two different rings, together may in turn set up a further mono- or poly-cyclic ring system;
R¹ and R² are the same or different H or an aliphatic or aromatic hydrocarbon radical having from 1 to 20 carbon atoms;
a is the same or different 0, 1, 2, 3 or 4, preferably 0, 1 or 2;
b is the same or different 0, 1, 2 or 3, preferably 0 or 1;
n is 1, 2 or 3.

2. A compound according to formulae (Ia) and (IIa) 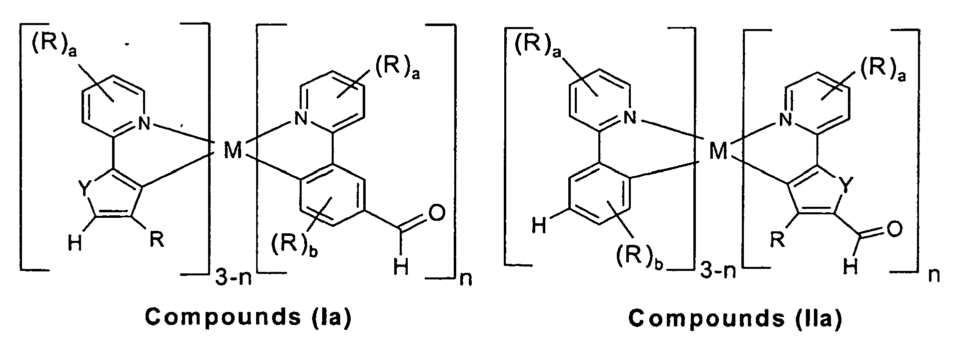 wherein the symbols and indices have the following meanings:
M is Rh, Ir;
Y is the same or different O, S, Se;
R is the same or different on each occurrence H, F, Cl, Br, NO₂, CN, a straight-chain or branched or cyclic alkyl or alkoxy group having from 1 to 20 carbon atoms, wherein one or more non-adjacent CH₂ groups may have been replaced by -O-, -S-, -NR¹- or -CONR² - and wherein one or more H atoms may have been replaced by F, or an aryl or heteroaryl group having from 4 to 14 carbon atoms which may be substituted by one or more, non-aromatic radicals R; a plurality of substituents R, both at the same ring and at the two different rings, together may in turn set up a further mono- or poly-cyclic ring system;
R¹ and R² are the same or different H or an aliphatic or aromatic hydrocarbon radical having from 1 to 20 carbon atoms;
a is the same or different 0, 1, 2, 3 or 4, preferably 0, 1 or 2;
b is the same or different 0, 1, 2 or 3, preferably 0 or 1;
n is 1, 2 or 3.

3. A process for the preparation of the compounds defined in claim 1, by reaction of compounds (III) or (IV) 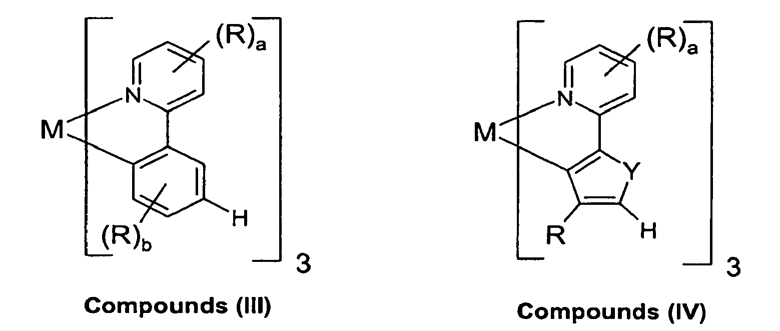 wherein M and the radicals and indices Y, R, a and b have the meanings given in claim 1, with formylating agents.

4. A process according to claim 3, **characterised in that** as formylating agents there are used formamides and an inorganic or organic acid halide in a ratio of from 1 : 1 to 100 : 1.

5. A process according to claim 4, **characterised in that** as formamide there is used N-methyl-formamide (MFA), N,N-dimethyl-formamide (DMF), N-methyl-formanilide.

6. A process according to claim 4 and/or 5, **characterised in that** as inorganic or organic acid halides there are used phosphorus oxide trichloride, thionyl chloride, sulfuryl chloride and oxalyl chloride.

7. A process according to claim 3, **characterised in that** as formylating agents there are used organic dihalomethyl ethers and Lewis acids in a ratio of from 1 : 1 to 1: 4.

8. A process according to claim 7, **characterised in that** as dihalomethyl ether there is used 1,1-dichloromethoxy-methane, -ethane, -propane or-butane,

9. A process according to claim 7, **characterised in that** as Lewis acids there are used titanium(IV) chloride, tin(IV) chloride or aluminium(III) chloride.

10. A process according to claim 3, **characterised in that** there is used a stoichiometric ratio of the formylating agents according to claim 4 or 7 relative to the compounds (III) or (IV) of 1 : 1.

11. A process according to claim 3, **characterised in that** there is used a stoichiometric ratio of the formylating agents according to claim 4 or 7 relative to the compounds (III) or (IV) of 2 : 1.

12. A process according to claim 3, **characterised in that** there is used a stoichiometric ratio of the formylating agents according to claim 4 or 7 relative to the compounds (III) or (IV) of from 3 : 1 to 100 : 1.

13. Compounds according to claim 1 or 2, **characterised in that** their purity (determined by means of ¹H-NMR or HPLC) is more than 99 %.

14. Use of compounds according to claim 1 or claim 2 for the production of conjugated or partially conjugated homo- or co-polymer,

15. Electrical component comprising conjugated or partially conjugated homo- or co-polymer which were produced by the use of the compounds according to claim 1 or 2.

16. Component according to claim 15, **characterised in that** it is an organic light-emitting diode (OLED), an organic integrated circuit (O-IC), an organic field effect transistor (OFET), an organic thin-film transistor (OTFT), an organic solar cell (O-SC), an organic laser diode (O-laser), an organic colour filter for liquid crystal displays or an organic photoreceptor.

## Revendications

1. Composé selon les formules (I) et (II) 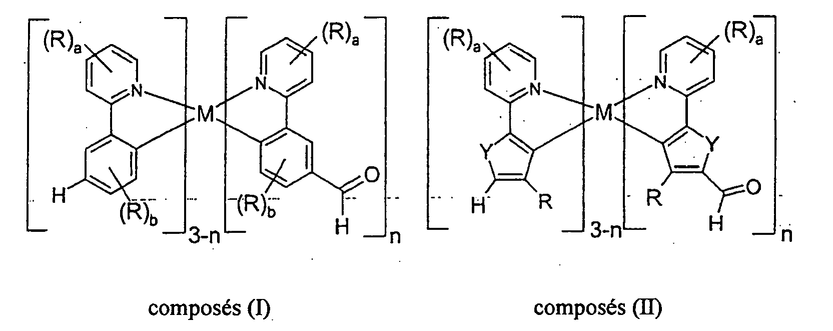 où les symboles et indices ont la signification suivante :
M est Rh, Ir
Y, identique ou différent, est O, S, Se
R, identique ou différent à chaque occurrence, est H, F, CI, Br, NO₂, CN, un groupe alkyle ou alcoxy linéaire ou ramifié ou cyclique ayant 1 à 20 atomes C, où un ou plusieurs groupes CH₂ non voisins peuvent être remplacés par -O-, -S-, - NR¹- ou -CONR²- et où un ou plusieurs atomes H peuvent être remplacés par F, ou un groupe aryle ou hétéroaryle ayant 4 à 14 atomes C qui peut être substitué par un ou plusieurs goupements R non aromatiques ; où plusieurs substituants R, tant sur le même cycle que sur les deux cycles différents, peuvent former ensemble de nouveau un autre système cyclique mono- ou polycyclique ;
R¹ et R², identiques ou différents, sont H ou un goupement hydrocarboné aliphatique ou aromatique ayant 1 à 20 atomes C,
a, identique ou différent, est 0, 1, 2, 3 ou 4, de préférence 0, 1 ou 2,
b, identique ou différent, est 0, 1, 2 ou 3, de préférence 0 ou 1,
n est 1, 2 ou 3.

2. Composé selon les formules (Ia) et (IIa) 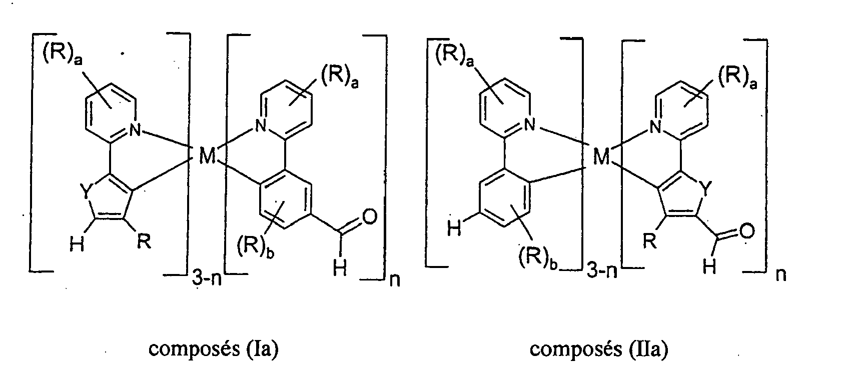 où les symboles et indices ont la signification suivante :
M est Rh, Ir
Y, identique ou différent, est O, S, Se
R, identique ou différent à chaque occurrence, est H, F, Cl, Br, NO₂, CN, un groupe alkyle ou alcoxy linéaire ou ramifié ou cyclique ayant 1 à 20 atomes C, où un ou plusieurs groupes CH₂ non voisins peuvent être remplacés par -O-, -S-, -NR¹- ou -CONR² - et où un ou plusieurs atomes H peuvent être remplacés par F, ou un groupe aryle ou hétéroaryle ayant 4 à 14 atomes C qui peut être substitué par un ou plusieurs goupements R non aromatiques ; où plusieurs substituants R, tant sur le même cycle que sur les deux cycles différents, peuvent former ensemble de nouveau un autre système cyclique mono- ou polycyclique ;
R¹ et R², identiques ou différents, sont H ou un goupement hydrocarboné aliphatique ou aromatique ayant 1 à 20 atomes C,
a, identique ou différent, est 0, 1, 2, 3 ou 4, de préférence 0, 1 ou 2,
b, identique ou différent, est 0, 1, 2 ou 3, de préférence 0 ou 1,
n est 1, 2 ou 3.

3. Procédé de production des composés définis dans la revendication 1 par réaction des composés (III) ou (IV) 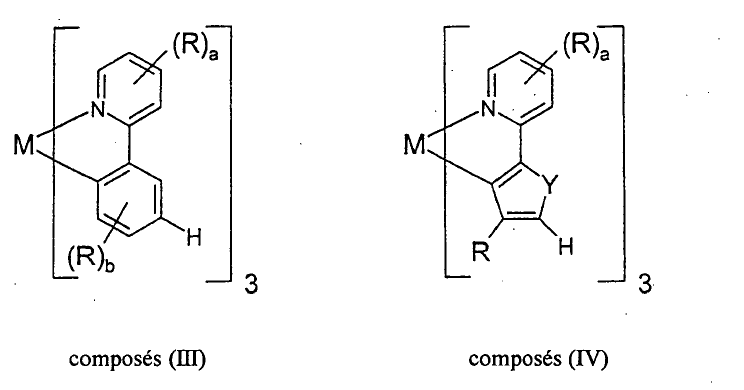 où M et les groupements et indices Y, R, a et b ont les significations citées dans la revendication 1, avec des agents de formylation.

4. Procédé selon la revendication 3 **caractérisé en ce que** des formamides et un halogénure d'acide inorganique ou organique sont utilisés dans le rapport 1 : 1 à 100 : 1 comme agents de formylation.

5. Procédé selon la revendication 4 **caractérisé en ce que** le N-méthylformamide (MFA), le N,N-diméthylformamide (DMF), le N-méthylformanilide sont utilisés comme formamide.

6. Procédé selon la revendication 4 et/ou 5 **caractérisé en ce que** le trichlorure d'oxyde de phosphore, le chlorure de thionyle, le chlorure de sulfuryle et le chlorure d'oxalyle sont utilisés comme halogénures d'acides inorganiques ou organiques.

7. Procédé selon la revendication 3 **caractérisé en ce que** des dihalogénométhyléthers et des acides de Lewis sont utilisés dans le rapport 1 : 1 à 1 : 4 comme agents de formylation.

8. Procédé selon la revendication 7 **caractérisé en ce que** le 1,1-dichlorométhoxyméthane, -éthane, -propane ou -butane est utilisé comme dihalogénométhyléther.

9. Procédé selon la revendication 7 **caractérisé en ce que** le chlorure de titane (IV), le chlorure d'étain (IV) ou le chlorure d'aluminium (III) est utilisé comme acide de Lewis.

10. Procédé selon la revendication 3 **caractérisé en ce qu'**un rapport stoechiométrique des agents de formylation selon les revendications 4 ou 7 aux composés (III) ou (IV) de 1 : 1 est utilisé.

11. Procédé selon la revendication 3 **caractérisé en ce qu'**un rapport stoechiométrique des agents de formylation selon les revendications 4 ou 7 aux composés (IM) ou (IV) de 2 : 1 est utilisé.

12. Procédé selon la revendication 3 **caractérisé en ce qu'**un rapport stoechiométrique des agents de formylation selon les revendications 4 ou 7 aux composés (III) ou (IV) de 3 : 1 à 100 : 1 est utilisé.

13. Composés selon la revendication 1 ou 2 **caractérisés en ce que** leur pureté (déterminée par RMN de 1H ou CLHP) est supérieure à 99 %.

14. Utilisation de composés selon la revendication 1 ou la revendication 2 pour la production d'homo- ou copolymères conjugués ou partiellement conjugués.

15. Composant électrique contenant des homo- ou copolymères conjugués ou partiellement conjugués qui ont été produits par l'utilisation de composés selon la revendication 1 ou 2.

16. Composant selon la revendication 15 **caractérisé en ce qu'**il s'agit d'une diode électroluminescente organique (OLED), d'un circuit intégré organique (O-IC), d'un transistor à effet de champ organique (OFET), d'un transistor à couche mince organique (OTFT), d'une cellule solaire organique (O-SC), d'une diode laser organique (O-laser), d'un filtre coloré organique pour Liquid-Crystal Displays ou d'un photorécepteur organique.
